(19) Europäisches Patentamt
European Patent Office
Office européen des brevets

(11) EP 3 376 242 B1

(12) **EUROPEAN PATENT SPECIFICATION**

(45) Date of publication and mention
of the grant of the patent:
**15.03.2023 Bulletin 2023/11**

(51) International Patent Classification (IPC):
**G01R 31/34** (2006.01)    **H02P 29/024** (2016.01)

(21) Application number: **16863872.4**

(52) Cooperative Patent Classification (CPC):
**G01R 31/346; H02P 29/0241;** G01R 31/343

(22) Date of filing: **24.08.2016**

(86) International application number:
**PCT/JP2016/074685**

(87) International publication number:
**WO 2017/081908 (18.05.2017 Gazette 2017/20)**

(54) **ELECTRIC MOTOR DIAGNOSIS DEVICE**

ELEKTROMOTORDIAGNOSEVORRICHTUNG

DISPOSITIF DE DIAGNOSTIC DE MOTEUR ÉLECTRIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **11.11.2015 JP 2015220890**

(43) Date of publication of application:
**19.09.2018 Bulletin 2018/38**

(73) Proprietor: **Mitsubishi Electric Corporation
Chiyoda-ku
Tokyo 100-8310 (JP)**

(72) Inventors:
• **MIYAUCHI Toshihiko
Tokyo 100-8310 (JP)**
• **KANEMARU Makoto
Tokyo 100-8310 (JP)**
• **MORI Mitsugi
Tokyo 100-8310 (JP)**
• **TSUKIMA Mitsuru
Tokyo 100-8310 (JP)**

(74) Representative: **Sajda, Wolf E.
Meissner Bolte Patentanwälte
Rechtsanwälte Partnerschaft mbB
Postfach 86 06 24
81633 München (DE)**

(56) References cited:
EP-A1- 2 725 370          WO-A1-2005/085792
WO-A1-2014/156386          CN-A- 102 135 600

JP-A- 2012 186 973          US-A- 5 477 163
US-A- 5 594 175          US-A- 6 144 924
US-B1- 6 262 550

• KATO T ET AL: "Diagnosis of multi-phase turn faults of induction motor stator windings", POWER ELECTRONICS AND DRIVE SYSTEMS, 2009. PEDS 2009. INTERNATIONAL CONFERENCE ON, IEEE, PISCATAWAY, NJ, USA, 2 November 2009 (2009-11-02), pages 144-149, XP031614566, ISBN: 978-1-4244-4166-2
• TOSHIJI KATO ET AL: "Diagnosis of multi-turn faults of induction motor by direct detection of asymmetry admittance component", POWER ELECTRONICS AND DRIVE SYSTEMS (PEDS), 2013 IEEE 10TH INTERNATIONAL CONFERENCE ON, IEEE, 22 April 2013 (2013-04-22), pages 778-783, XP032420859, DOI: 10.1109/PEDS.2013.6527122 ISBN: 978-1-4673-1790-0
• NETI P ET AL: "Stator inter-turn fault analysis of reluctance synchronousmotor", ELECTRICAL AND COMPUTER ENGINEERING, 2005. CANADIAN CONFERENCE ON SASKATOON, SK, CANADA MAY 1-4, 2005, PISCATAWAY, NJ, USA, IEEE, PISCATAWAY, NJ, USA, 1 May 2005 (2005-05-01), pages 1283-1286, XP010869038, DOI: 10.1109/CCECE.2005.1557211 ISBN: 978-0-7803-8885-7

**Description**

TECHNICAL FIELD

The present invention relates to an electric motor diagnosis device that is used at, for example, a control center which is a closed distribution board, and that diagnoses whether or not there is an abnormality in an electric motor.

BACKGROUND ART

Conventionally, an electric equipment soundness diagnosis system is proposed which includes: feature amount detection means for detecting a feature amount from current flowing through electric equipment which is a diagnosis target; and calculation storage means for deriving and storing, in advance, an average and a standard deviation of a feature amount obtained by the feature amount detection means when the electric equipment is normal, wherein, in diagnosis of an electric equipment, whether the electric equipment is normal or abnormal is diagnosed on the basis of a probability value of existence inside an ellipse determined on the basis of the feature amount obtained by the feature amount detection means and the average and standard deviation stored in the calculation storage means (for example, Patent Document 1). US 5 477 163 A discloses a method for detecting turn faults in an induction motor which is based on measuring at least two motor phase currents, at least two motor phase voltages, and the negative sequence impedance, and estimating the motor torque based on the measured values.

CITATION LIST

PATENT DOCUMENT

Patent Document 1: Japanese Laid-Open Patent Publication JP 2012-220 485 A.

SUMMARY OF THE INVENTION

PROBLEMS TO BE SOLVED BY THE INVENTION

In a conventional electric equipment soundness diagnosis system, a feature amount of current flowing through the electric motor which is electric equipment to be diagnosed is detected, and whether or not winding short-circuit (layer short-circuit) has occurred in the electric motor is diagnosed on the basis of a probability value of existence inside an ellipse determined on the basis of the feature amount and the average and standard deviation derived and stored in advance.

However, when load torque varies in the electric motor, current varies and detection error occurs. Therefore, there is a problem that it is difficult to apply this diagnosis system to an electric motor having a greatly varying load.

The present invention has been made to solve the above problem, and an object of the present invention is to provide an electric motor diagnosis device capable of diagnosing whether or not winding short-circuit (layer short-circuit) has occurred in an electric motor even if a load of the electric motor varies.

SOLUTION TO THE PROBLEMS

An electric motor diagnosis device according to the present invention includes:

- a load torque calculation unit for calculating load torque of an electric motor, using voltage and current sampled and input from a main circuit to which the electric motor is connected;
- a negative-phase-sequence admittance characteristics storage unit storing load torque/negative-phase-sequence admittance characteristics obtained in advance when the electric motor is normal;
- a negative-phase-sequence admittance calculation unit for calculating a negative-phase-sequence admittance $Y_n$ from the load torque calculated by the load torque calculation unit, using the load torque/negative-phase-sequence admittance characteristics stored in the negative-phase-sequence admittance characteristics storage unit;
- a winding short-circuit evaluation value calculation unit for calculating a winding short-circuit evaluation value $\Delta$ on the basis of the negative-phase-sequence admittance $Y_n$ calculated by the negative-phase-sequence admittance calculation unit, negative-phase-sequence current $I_{sn}$ calculated from input current, and negative-phase-sequence voltage $V_{sn}$ calculated from input voltage according to the formula $\Delta = |I_{sn} - Y_n \cdot V_{sn}|$; and
- a winding short-circuit determination unit for determining that winding short-circuit has occurred, when the winding short-circuit evaluation value $\Delta$ calculated by the winding short-circuit evaluation value calculation unit is equal to or greater than a threshold value.

EFFECT OF THE INVENTION

According to the present invention, the electric motor diagnosis device includes: a load torque calculation unit for calculating load torque of an electric motor, using voltage and current sampled and input from a main circuit to which the electric motor is connected; a negative-phase-sequence admittance characteristics storage unit storing load torque/negative-phase-sequence admittance characteristics obtained in advance when the electric motor is normal; a negative-phase-sequence admittance calculation unit for calculating a negative-phase-sequence admittance from the load torque calculated by the load torque calculation unit, using the load torque/negative-phase-sequence admittance characteristics stored in the negative-phase-sequence admittance characteristics storage unit; a winding short-circuit evaluation value calculation unit for calculating a winding short-circuit evaluation value on the basis of the negative-phase-sequence admittance calculated by the negative-phase-sequence admittance calculation unit, negative-phase-sequence current calculated from input current, and negative-phase-sequence voltage calculated from input voltage; and a winding short-circuit determination unit for determining that winding short-circuit has occurred, when the winding short-circuit evaluation value calculated by the winding short-circuit evaluation value calculation unit is equal to or greater than a threshold value.

Thus, since the winding short-circuit evaluation value is calculated using the negative-phase-sequence admittance according to the load torque, the present invention provides an effect of obtaining an electric motor diagnosis device capable of diagnosing whether or not winding short-circuit (layer short-circuit) has occurred in an electric motor, even if a load of the electric motor varies.

BRIEF DESCRIPTION OF THE DRAWINGS

FIG. 1    is a schematic configuration diagram showing the installation state of an electric motor diagnosis device according to Embodiment 1 of the present invention.

FIG. 2    is a block diagram showing the configuration of a logical calculation unit of the electric motor diagnosis device according to Embodiment 1 of the present invention.

FIG. 3    is a block diagram showing the configuration of a storage unit of the electric motor diagnosis device according to Embodiment 1 of the present invention.

FIG. 4    illustrates a relationship between a sampling speed, and a forgetting coefficient and a scale factor, in the electric motor diagnosis device according to Embodiment 1 of the present invention.

FIG. 5    is a flowchart showing operation of a learning period unit of the electric motor diagnosis device according to Embodiment 1 of the present invention.

FIG. 6    is a flowchart showing operation of a winding short-circuit analysis unit of the electric motor diagnosis device according to Embodiment 1 of the present invention.

FIG. 7    illustrates load torque/negative-phase-sequence admittance characteristics stored in a negative-phase-sequence admittance characteristics storage unit of the electric motor diagnosis device according to Embodiment 1 of the present invention.

FIG. 8    illustrates a winding short-circuit evaluation value of the electric motor diagnosis device according to Embodiment 1 of the present invention.

DESCRIPTION OF EMBODIMENTS

Hereinafter, embodiments of the present invention will be described, while the same or corresponding parts are denoted by the same reference characters in the drawings.

Embodiment 1

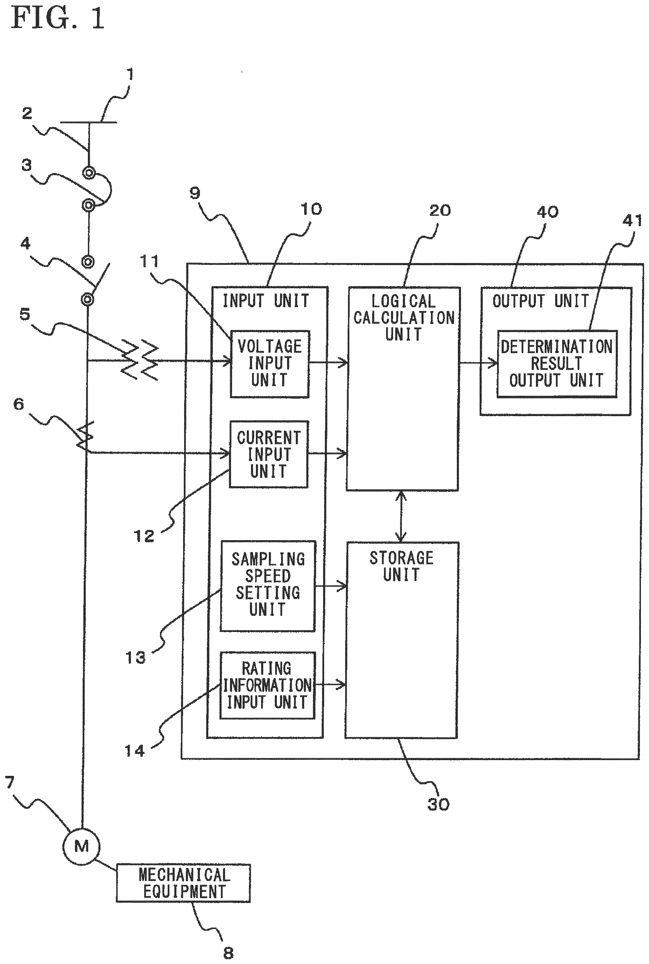

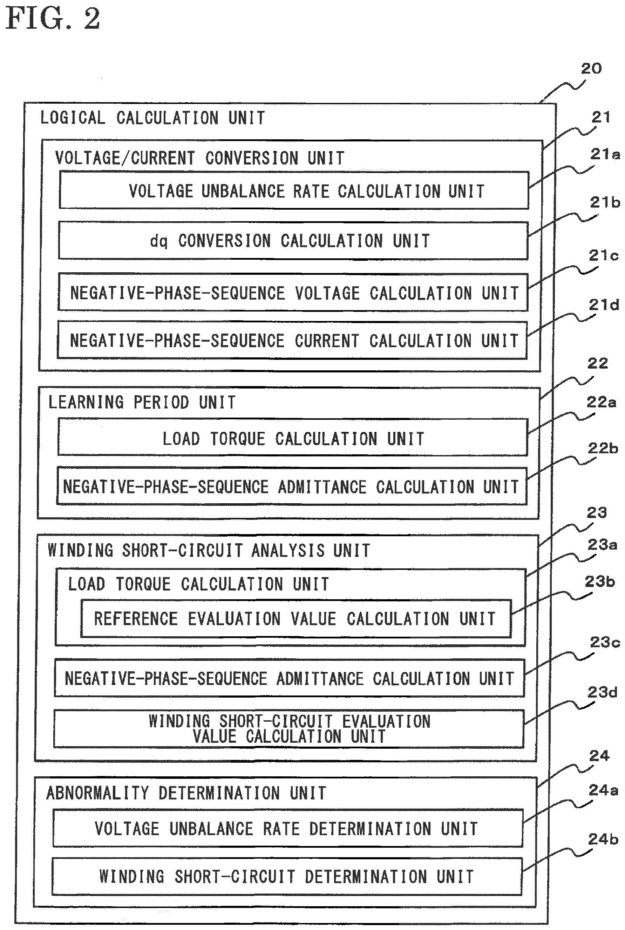

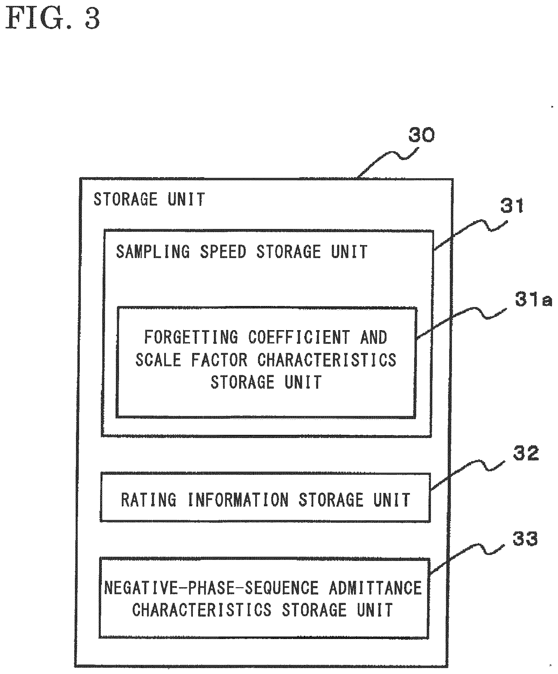

FIG. 1 is a schematic configuration diagram showing the installation state of an electric motor diagnosis device according to Embodiment 1 of the present invention. FIG. 2 is a block diagram showing the configuration of a logical calculation unit of the electric motor diagnosis device according to Embodiment 1 of the present invention. FIG. 3 is a block diagram showing the configuration of a storage unit of the electric motor diagnosis device according to Embodiment 1 of the present invention.

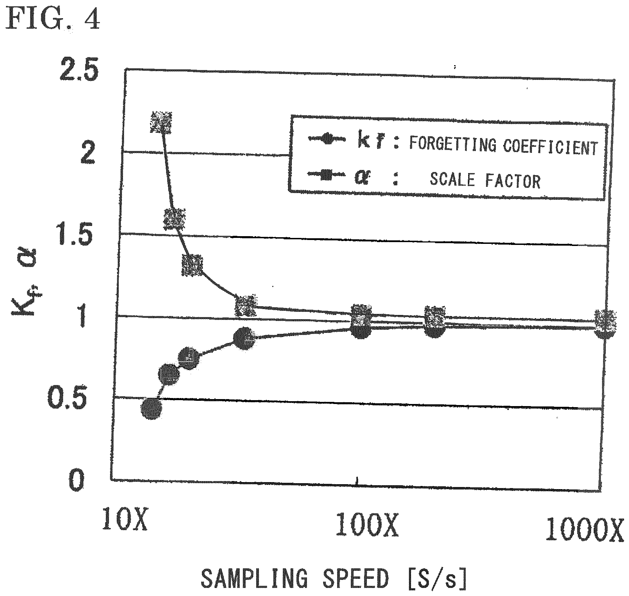

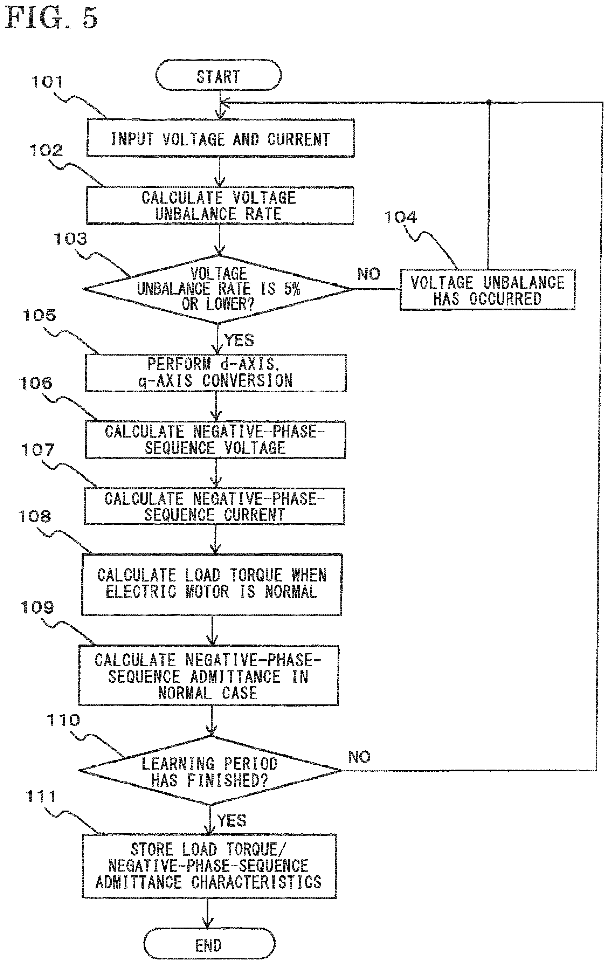

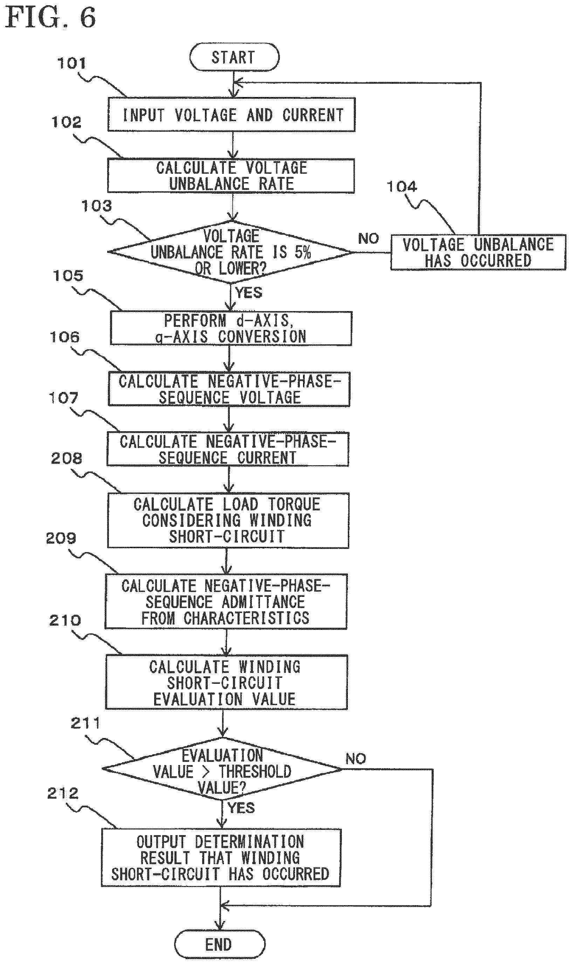

FIG. 4 illustrates a relationship between a sampling speed, and a forgetting coefficient and a scale factor, in the electric motor diagnosis device according to Embodiment 1 of the present invention. FIG. 5 is a flowchart showing operation of a learning period unit of the electric motor diagnosis device according to Embodiment 1 of the present invention. FIG. 6 is a flowchart showing operation of a winding short-circuit analysis unit of the electric motor diagnosis device according to Embodiment 1 of the present invention.

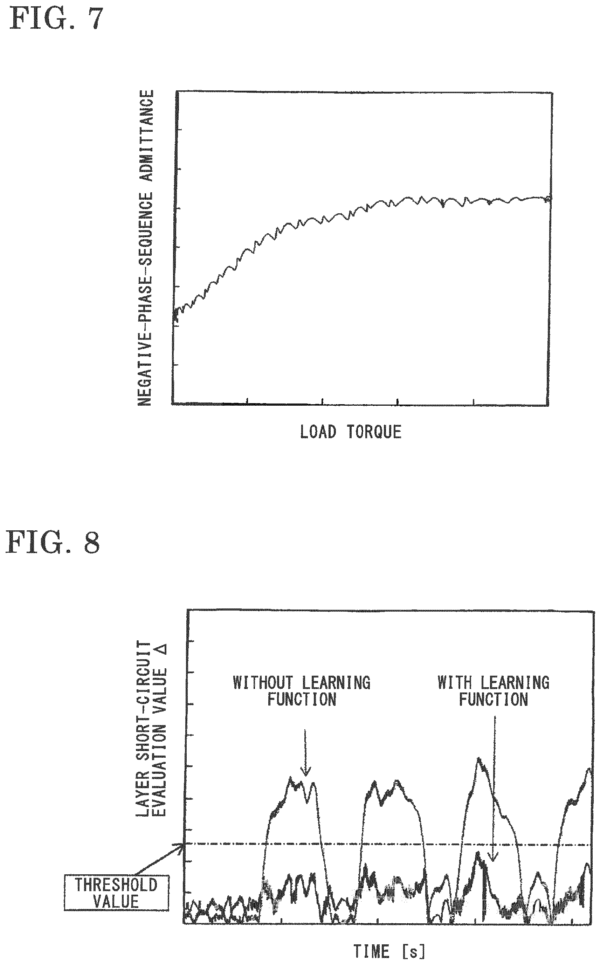

FIG. 7 illustrates load torque/negative-phase-sequence admittance characteristics stored in a negative-phase-sequence admittance characteristics storage unit of the electric motor diagnosis device according to Embodiment 1 of the present invention. FIG. 8 illustrates a winding short-circuit evaluation value of the electric motor diagnosis device according to Embodiment 1 of the present invention.

In FIG. 1, a main circuit 2 led from a power grid 1 is provided with: a wiring circuit breaker 3; an electromagnetic contactor 4; a voltage detector 5 such as an instrument voltage transformer for detecting interphase voltages for three phase pairs of the three-phase main circuit 2; and a current detector 6 such as an instrument transformer for detecting load currents for three phases (at least two phases) of the main circuit 2.

An electric motor 7 such as a three-phase induction motor which is a load is connected to the main circuit 2, and mechanical equipment 8 is operated and driven by the electric motor 7. An electric motor diagnosis device 9 is mainly used at a control center which is a closed distribution board. The electric motor diagnosis device 9 includes an input unit 10, a logical calculation unit 20, a storage unit 30, and an output unit 40.

The input unit 10 is provided with: a voltage input unit 11 to which voltage detected by the voltage detector 5 is input (hereinafter, referred to as "sampled and input") at a predetermined sampling speed; a current input unit 12 to which current detected by the current detector 6 is sampled and input; a sampling speed setting unit 13 for setting the sampling speed; and a rating information input unit 14 to which rating information of the electric motor 7 and the like are input.

In the sampling speed setting unit 13, setting is made such that sampling is performed at a sampling speed of 100 samples per second and during 10 seconds, for example. Thus, 1000 sampled data are to be obtained. The set sampling speed and the like are stored into a sampling speed storage unit 31 shown in FIG. 3, of the storage unit 30. There is a correlation as shown in FIG. 4 between the sampling speed, and a forgetting coefficient kf and a scale factor $\alpha$.

Therefore, the correlation shown in FIG. 4 obtained as a result of actual measurement performed in advance by a manufacturer of the diagnosis device, for example, is stored as a data table in a forgetting coefficient and scale factor characteristics storage unit 31a. Once the sampling speed is set initially, the sampling speed on the same condition is applied to all subsequent diagnoses for that electric motor. Therefore, also the forgetting coefficient kf and the scale factor $\alpha$ are calculated from the initially set sampling speed, using the correlation as shown FIG. 4, and are stored in the sampling speed storage unit 31.

The rating information input unit 14 is used for inputting, in advance, a power supply frequency, the rated output, rated voltage, rated current, rated rotation rate, etc., of the electric motor 7, and the number of magnetic poles, a winding resistance value, etc., used for calculation of load torque. The input rating information and the like are stored into a rating information storage unit 32 shown in FIG. 3, of the storage unit 30.

The rating information and the like can be easily acquired by looking at a catalog of the manufacturer of the electric motor 7 or the rating plate attached to the electric motor 7. It is noted that, if there are a plurality of electric motors 7 as diagnosis targets, the rating information of all the electric motors 7 that are diagnosis targets needs to be input in advance. In general, when the temperature of the stator winding of the electric motor 7 rises, a winding resistance value Rs thereof increases.

Therefore, it is possible that, for example, the correlation between the winding resistance value Rs and the temperature obtained through experiments by a manufacturer of the electric motor 7 or the like is set in advance in the rating information storage unit 32, and the temperature of the stator winding at the time of sampling of voltage and current is detected and input, whereby the winding resistance value Rs can be accurately obtained on the basis of the set correlation. Alternatively, the winding resistance value Rs may be obtained by being calculated from the detected voltage and current. Thus, the method for obtaining the winding resistance value Rs is not limited to the method described above.

The configuration of the logical calculation unit 20 will be described with reference to FIG. 2. The logical calculation unit 20 includes: a voltage/current conversion unit 21 for converting voltage input from the voltage input unit 11 and current input from the current input unit 12, to values that are suitable for diagnosis analysis and the like; a learning period unit 22 for calculating, in advance, load torque/negative-phase-sequence admittance characteristics when the electric motor 7 is normal, and storing the load torque/negative-phase-sequence admittance characteristics in a negative-phase-sequence admittance characteristics storage unit 33 shown in FIG. 3, of the storage unit 30; a winding short-circuit analysis unit 23 for analyzing whether or not winding short-circuit (layer short-circuit) has occurred in the electric motor 7; and an abnormality determination unit 24 for determining whether or not there is an abnormality.

The voltage/current conversion unit 21 includes: a voltage unbalance rate calculation unit 21a for calculating an unbalance rate of interphase voltages for three phase pairs input from the voltage input unit 11; a dq conversion calculation unit 21b for converting voltage input from the voltage input unit 11 and current input from the current input unit 12, to voltages and currents in the d-axis direction and q-axis direction (hereinafter, referred to as dq-axis directions) that are suitable for calculation of load torque; a negative-phase-sequence voltage calculation unit 21c for converting voltage input from the voltage input unit 11, to negative-phase-sequence voltage Vsn that is suitable for winding short-circuit analysis and the like; and a negative-phase-sequence current calculation unit 21d for converting current input from the current input unit 12, to negative-phase-sequence current Isn that is suitable for winding short-circuit analysis and the like.

The learning period unit 22 includes: a load torque calculation unit 22a for calculating load torque when the electric motor 7 is normal, using the voltage and current converted by the dq conversion calculation unit 21b; and a negative-phase-sequence admittance calculation unit 22b for calculating the negative-phase-sequence admittance when the electric motor 7 is normal, so as to be associated with load torque, using the negative-phase-sequence voltage calculated by the negative-phase-sequence voltage calculation unit 21c and the negative-phase-sequence current calculated by the negative-phase-sequence current calculation unit 21d.

In this case, the negative-phase-sequence admittance is calculated using as many input voltages and currents as possible for each load torque variation over a load torque range from zero to the maximum value that can be used, whereby load torque/negative-phase-sequence admittance characteristics as shown in FIG. 7 can be obtained. The obtained characteristics are stored into the negative-phase-sequence admittance characteristics storage unit 33 shown in FIG. 3, of the storage unit 30.

The winding short-circuit analysis unit 23 includes: a load torque calculation unit 23a for calculating load torque considering winding short-circuit of the electric motor 7, using the voltage and current converted by the dq conversion calculation unit 21b; a reference evaluation value calculation unit 23b for calculating a winding short-circuit reference evaluation value to be used in the load torque calculation unit 23a; a negative-phase-sequence admittance calculation unit 23c for calculating a negative-phase-sequence admittance, using the load torque/negative-phase-sequence admittance characteristics shown in FIG. 7 which are stored in the negative-phase-sequence admittance characteristics storage unit 33 so as to be associated with the load torque calculated by the load torque calculation unit 23a; and a winding short-circuit evaluation value calculation unit 23d for calculating a winding short-circuit evaluation value, using the negative-phase-sequence admittance calculated by the negative-phase-sequence admittance calculation unit 23c, the negative-phase-sequence voltage calculated by the negative-phase-sequence voltage calculation unit 21c, and the negative-phase-sequence current calculated by the negative-phase-sequence current calculation unit 21d.

The abnormality determination unit 24 includes: a voltage unbalance rate determination unit 24a for determining whether or not voltage of the power grid 1 is in a stable state in which the maximum value of the voltage unbalance rate calculated by the voltage unbalance rate calculation unit 21a is, for example, 5 % or lower; and a winding short-circuit determination unit 24b for determining that winding short-circuit has occurred, when the winding short-circuit evaluation value calculated by the winding short-circuit evaluation value calculation unit 23d exceeds a predetermined threshold value. It is noted that, when abnormality is recognized in the abnormality determination unit 24, the abnormality is reported to an operator by screen output, an alarm, an abnormality lamp, or the like from a determination result output unit 41 of the output unit 40.

The configuration of the storage unit 30 will be described with reference to FIG. 3. The storage unit 30 includes: the sampling speed storage unit 31 for storing the sampling speed and the like set by the sampling speed setting unit 13; the forgetting coefficient and scale factor characteristics storage unit 31a in which the correlation shown in FIG. 4 which is obtained as a result of actual measurement performed in advance by a manufacturer of the diagnosis device is stored as a data table; the rating information storage unit 32 for storing the rating information of the electric motor 7 and the like input from the rating information input unit 14; and the negative-phase-sequence admittance characteristics storage unit 33 in which the load torque/negative-phase-sequence admittance characteristics shown in FIG. 7 obtained in advance by the learning period unit 22 is stored.

Next, operation of the logical calculation unit 20 will be described with reference to the flowcharts shown in FIG. 5 and FIG. 6. The electric motor diagnosis device 9 has: a learning period mode shown in the flowchart in FIG. 5, which is initially executed when the diagnosis device is introduced; and a winding short-circuit analysis mode shown in the flowchart in FIG. 6. The winding short-circuit analysis mode is activated at predetermined time intervals, e.g., every ten minutes, to perform abnormality diagnosis for the electric motor 7.

First, acquisition of load torque/negative-phase-sequence admittance characteristics, which needs to be performed as initial setting when the electric motor diagnosis device 9 is introduced, will be described with reference to the flowchart shown in FIG. 5. This is performed at an early stage when the equipment is just introduced and the electric motor 7 and the mechanical equipment 8 are comparatively new so that it is ensured that there is no failure.

In step 101, voltages Vuv, Vvw, Vwu for three phase pairs are input from the voltage input unit 11 at the sampling speed set by the sampling speed setting unit 13 and stored in the sampling speed storage unit 31, and currents Iu, Iv, Iw for three phases are sampled and input from the current input unit 12.

In step 102, the voltage unbalance rate calculation unit 21a calculates voltage unbalance rates of the input interphase voltages for three phase pairs. The voltage unbalance rate can be calculated by a formula:

voltage unbalance rate = (interphase voltage - average voltage)/average voltage × 100 %.

Therefore, if the voltage unbalance rate of the interphase voltage Vuv between u phase and v phase is denoted by Uuv, the voltage unbalance rate of the interphase voltage Vvw between v phase and w phase is denoted by Uvw, the voltage unbalance rate of the interphase voltage Vwu between w phase and u phase is denoted by Uwu, and the average voltage is denoted by Vavg, the average voltage can be calculated as

$$Vavg = (Vuv + Vvw + Vwu)/3,$$

the voltage unbalance rate of the interphase voltage between u phase and v phase can be calculated as

$$Uuv = (Vuv \text{ - } Vavg)/Vavg \times 100 \text{ \%},$$

the voltage unbalance rate of the interphase voltage between v phase and w phase can be calculated as

$$Uvw = (Vvw \text{ - } Vavg)/Vavg \times 100 \text{ \%},$$

and the voltage unbalance rate of the interphase voltage between w phase and u phase can be calculated as

$$Uwu = (Vwu \text{ - } Vavg)/Vavg \times 100 \text{ \%}.$$

In step 103, the voltage unbalance rate determination unit 24a determines whether or not the maximum value of the three voltage unbalance rates calculated by the voltage unbalance rate calculation unit 21a is 5 % or lower. If the maximum value exceeds 5 % (NO), as shown in step 104, it is determined that voltage unbalance has occurred in the power grid 1 and the present condition is not suitable for diagnosis, and thus the process returns to step 101 without performing anything. On the other hand, if the maximum value of the voltage unbalance rates is 5 % or lower (YES), the power grid 1 is in a normal state in which three phases u, v, w are balanced, and thus the process proceeds to step 105.

In step 105, the dq conversion calculation unit 21b converts the input voltage and current, to voltages and currents in the dq-axis directions that are suitable for calculation of load torque.

The calculation by the dq conversion calculation unit 21b will be described. First, in dq conversion of three-phase currents, if the three phases u, v, w are balanced, only current information for two phases is sufficient. Therefore, using currents Iu and Iv for two phases input from the current input unit 12, current id in the d-axis direction and current iq in the q-axis direction are calculated by a conversion formula shown in Expression (1).

[Mathematical 1]

$$\begin{pmatrix} i_d \\ i_q \end{pmatrix} = \begin{pmatrix} \dfrac{2}{3} & -\dfrac{1}{3} & -\dfrac{1}{3} \\ 0 & \dfrac{1}{\sqrt{3}} & -\dfrac{1}{\sqrt{3}} \end{pmatrix} \begin{pmatrix} I_u \\ I_v \\ -(I_u + I_v) \end{pmatrix} = \begin{pmatrix} 1 & 0 \\ \dfrac{1}{\sqrt{3}} & \dfrac{2}{\sqrt{3}} \end{pmatrix} \begin{pmatrix} I_u \\ I_v \end{pmatrix} \qquad \cdots (1)$$

Similarly, also in the case of voltage, only voltage information for two phases is sufficient. However, normally, voltage is often measured as line-to-line voltage. Therefore, using voltages Vuv and Vvw for two phases (the subscript uv denotes "between u phase and v phase", and the subscript vw denotes "between v phase and w phase") input from the voltage input unit 11, voltage Vd in the d-axis direction and voltage Vq in the q-axis direction are calculated by a conversion formula shown in Expression (2).

[Mathematical 2]

$$\begin{pmatrix} v_d \\ v_q \end{pmatrix} = \begin{pmatrix} \dfrac{2}{3} & \dfrac{1}{3} \\ 0 & \dfrac{1}{\sqrt{3}} \end{pmatrix} \begin{pmatrix} v_{uv} \\ v_{vw} \end{pmatrix} \qquad \cdots \cdots \cdots \cdots \cdots \cdots (2)$$

In step 106, the negative-phase-sequence voltage calculation unit 21c calculates negative-phase-sequence voltage Vsn by conversion formulas shown in Expressions (3) to (5), using voltages Vuv, Vvw, Vwu for three phase input from the voltage input unit 11. Here, in Expression (3), Av is a value calculated by Expression (4), and Bv is a value calculated by Expression (5).

[Mathematical 3]

$$V_{sn} = \sqrt{\frac{A_v - \sqrt{3\left(4B_v - A_v^2\right)}}{18}} \qquad \cdots \cdots \cdots \cdots \cdots (3)$$

[Mathematical 4]

$$A_v = V_{uv}^2 + V_{vw}^2 + V_{wu}^2 \qquad \cdots \cdots \cdots \cdots \cdots (4)$$

[Mathematical 5]

$$B_v = V_{uv}^2 V_{vw}^2 + V_{vw}^2 V_{wu}^2 + V_{wu}^2 V_{uv}^2 \qquad \cdots \cdots \cdots \cdots (5)$$

In step 107, the negative-phase-sequence current calculation unit 21d calculates negative-phase-sequence current Isn by conversion formulas shown in Expressions (6) to (8), using currents Iu, Iv, Iw for three phases input from the current input unit 12. Here, in Expression (6), Ai is a value calculated by Expression (7), and Bi is a value calculated by Expression (8).

[Mathematical 6]

$$I_{sn} = \sqrt{\frac{A_i - \sqrt{3\left(4B_i - A_i^2\right)}}{6}} \qquad \cdots \cdots \cdots \cdots \cdots (6)$$

[Mathematical 7 ]

$$A_i = I_u^2 + I_v^2 + I_w^2 \qquad \cdots \cdots \cdots \cdots \cdots (7)$$

[Mathematical 8]

$$B_i = I_u^2 I_v^2 + I_v^2 I_w^2 + I_w^2 I_u^2 \qquad \cdots \cdots \cdots \cdots (8)$$

In step 108, the load torque calculation unit 22a of the learning period unit 22 calculates load torque when the electric motor 7 is normal, using the voltages and currents in the dq-axis directions converted by the dq conversion calculation unit 21b.

The calculation by the load torque calculation unit 22a will be described. The load torque calculation unit 22a calculates load torque Te by Expression (9), using currents id, iq in the dq-axis directions obtained through calculation by the dq conversion calculation unit 21b, the number of magnetic poles Pp of the electric motor 7 input from the rating information input unit 14 and stored in the rating information storage unit 32 in advance, and interlinkage magnetic fluxes $\phi$d, $\phi$q in the dq-axis directions of the stator winding of the electric motor 7.

[Mathematical 9]

$$T_e = \frac{3}{2} \cdot \frac{P_p}{2} \left\{ (\phi_d \cdot i_q) - (\phi_q \cdot i_d) \right\} - \frac{P_p}{2} \mu I_f \phi_q \quad \cdot \cdot \cdot (9)$$

Here, the interlinkage magnetic fluxes $\phi$d, $\phi$q in the dq-axis directions can be obtained by calculations of Expressions (10) to (14). The Expression (10) and Expression (11) are expressed using derivative, and accordingly, Expression (12) and Expression (13) are obtained through numerical analysis. Values obtained by calculations of Expression (14) and Expression (15) by multiplying results of calculations of Expression (12) and Expression (13) by a scale factor $\alpha$ are identified values obtained as final results of the interlinkage magnetic fluxes. The calculation result of Expression (14) corresponds to the interlinkage magnetic flux $\phi$d, and the calculation result of the Expression (15) corresponds to the interlinkage magnetic flux $\phi$q.

[Mathematical 10]

$$\frac{d\phi_d}{dt} = v_d - (i_d \cdot R_s) \qquad \cdot \cdot \cdot \cdot \cdot \cdot \cdot \cdot \cdot \cdot (10)$$

[Mathematical 11]

$$\frac{d\phi_q}{dt} = v_q - (i_q \cdot R_s) \qquad \cdot \cdot \cdot \cdot \cdot \cdot \cdot \cdot \cdot \cdot (11)$$

[Mathematical 12]

$$\Psi_d^n = k_f \cdot \Psi_d^{n-1} + \left\{ v_d^{n-1} + v_d^n - (i_d^{n-1} + i_d^n) \cdot R_s \right\} \cdot \frac{\Delta t}{2} \quad \cdot \cdot \cdot (12)$$

[Mathematical 13]

$$\Psi_q^n = k_f \cdot \Psi_q^{n-1} + \left\{ v_q^{n-1} + v_q^n - (i_q^{n-1} + i_q^n) \cdot R_s \right\} \cdot \frac{\Delta t}{2} \quad \cdot \cdot \cdot (13)$$

[Mathematical 14]

$$\widehat{\Psi}_d^n = \alpha \cdot \Psi_d^n \qquad \cdot \cdot \cdot \cdot \cdot \cdot \cdot \cdot \cdot \cdot (14)$$

[Mathematical 15]

$$\widehat{\Psi}_q^n = \alpha \cdot \Psi_q^n \qquad \cdot \cdot \cdot \cdot \cdot \cdot \cdot \cdot \cdot \cdot (15)$$

It is noted that the symbols used in Expressions (10) to (15) denote the following data: Vd and Vq are voltages in the dq-axis directions calculated by the dq conversion calculation unit 21b, id and iq are currents in the dq-axis directions calculated by the dq conversion calculation unit 21b, Rs is the winding resistance value of the electric motor 7, kf is a forgetting coefficient calculated from the set sampling speed using the characteristics shown in FIG. 4, $\alpha$ is a scale factor, calculated from the set sampling speed using the characteristics shown in FIG. 4, $\Psi$ is a symbol of numerical analysis of the interlinkage magnetic flux, a superscript n is a variable indicating usage of the n-th value of sampling, and a superscript n-1 is a variable indicating usage of the (n-1)th value of sampling. Therefore, n takes values of 1, 2, 3, ... A symbol $\Delta t$ denotes a sampling time width and is a value determined by the sampling speed. For example, if the sampling speed is 100 samples per second, the sampling time width $\Delta t$ is 0.01.

In addition, $\mu$ is a short-circuit rate in the case where a part of the stator winding of the electric motor 7 is short-circuited. If Nf turns of the number of turns N for each phase of the electric motor 7 are short-circuited, the short-circuit rate can be represented as $\mu$ = Nf/N. However, Expression (9) is for calculating load torque when the electric motor 7 is normal and winding short-circuit has not occurred. Therefore, the load torque is calculated by Expression (9) with the short-circuit rate set as $\mu$ = 0. It is noted that If is short-circuit current, but since the short-circuit rate $\mu$ is zero, the rightmost term in Expression (9) becomes zero and therefore the load torque can be calculated even if the short-circuit current If is not known.

In step 109, the negative-phase-sequence admittance calculation unit 22b of the learning period unit 22 calculates a negative-phase-sequence admittance when the electric motor 7 is normal, so as to be associated with the load torque calculated by the load torque calculation unit 22a.

Specifically, if the short-circuit rate $\mu$ is assumed to be sufficiently smaller than 1, i.e., $\mu$ << 1, relationships of Expressions (16) to (18) shown below are satisfied among positive-phase-sequence voltage Vsp, negative-phase-sequence voltage Vsn, positive-phase-sequence current Isp, negative-phase-sequence current Isn, a positive-phase-sequence admittance Yp, a negative-phase-sequence admittance Yn, and an asymmetrical admittance Ypn and an asymmetrical negative-phase-sequence admittance Ynp which are non-diagonal components with respect to the positive-phase-sequence admittance Yp and the negative-phase-sequence admittance Yn.

Here, in Expression (16), Ypp and Ynn are represented as Ypp = Yp + Ypn, Ynn = Yn + Ynp, respectively, and when winding short-circuit has not occurred, the short-circuit rate $\mu$ is zero. Therefore, the asymmetrical admittance Ypn and the asymmetrical negative-phase-sequence admittance Ynp shown in Expression (17) become zero, and the negative-phase-sequence admittance Yn can be calculated by Expression (19), using the negative-phase-sequence voltage Vsn calculated by the negative-phase-sequence voltage calculation unit 21c and the negative-phase-sequence current Isn calculated by the negative-phase-sequence current calculation unit 21d.

[Mathematical 16]

$$\begin{pmatrix} I_{sp} \\ I_{sn} \end{pmatrix} = \begin{pmatrix} Y_{pp} & Y_{pn} \\ Y_{np} & Y_{nn} \end{pmatrix} \begin{pmatrix} Y_{sp} \\ V_{sn} \end{pmatrix} \quad \cdots\cdots\cdots\cdots (1\,6)$$

[Mathematical 17]

$$Y_{pn} = Y_{np} = \frac{\mu^2}{3\left(j\mu\omega L_s + r_f + \mu r_s\right)} \quad \cdots\cdots\cdots (1\,7)$$

[Mathematical 18]

$$Y_p = \frac{r_r + js\omega L_r}{s\omega^2 L_m^2 + \left(r_s + j\omega L_s\right)\left(r_r + js\omega L_r\right)} \quad \cdots (18)$$

$$Y_n = \frac{r_r + j(2-s)\omega L_r}{(2-s)\omega^2 L_m^2 + \left(r_s + j\omega L_s\right)\left(r_r + j(2-s)\omega L_r\right)} \quad \cdots (18)$$

[Mathematical 19]

$$Y_n = \frac{I_{sn}}{V_{sn}} \qquad \cdots \cdots \cdots \cdots \cdots \cdots (19)$$

It is noted that the symbols used in Expression (17) and Expression (18) denote the following data: ω is a power supply angular velocity, rs is a winding resistance of the stator of the electric motor 7, rf is a short-circuit resistance, Ls is a stator leakage inductance, Lm is an excitation inductance, Lr is a rotor inductance, rr is a rotor resistance, s is a slip, and ω with "-" attached above is a power supply angular frequency.

In step 110, the learning period unit 22 confirms whether or not a sufficient number of data for obtaining the load torque/negative-phase-sequence admittance characteristics shown in FIG. 7 have been obtained. If the data amount is not sufficient, the learning period has not finished yet (NO) and therefore the process returns to step 101.

If the learning period has finished (YES), the process proceeds to step 111. In step 111, the obtained load torque/negative-phase-sequence admittance characteristics are stored into the negative-phase-sequence admittance characteristics storage unit 33 of the storage unit 30, and thus operation in the learning period mode is finished.

Next, operation in the winding short-circuit analysis mode will be described with reference to FIG. 6. In FIG. 6, operation from step 101 to step 107 is the same as in the learning period mode shown in FIG. 5, and therefore the description thereof is omitted.

In step 208, the load torque calculation unit 23a of the winding short-circuit analysis unit 23 calculates load torque by the load torque calculation Expression (20) considering winding short-circuit, which is obtained by deforming the load torque calculation Expression (9) used in the learning period mode.

In Expression (20), for the same symbols as in Expression (9), the same operation description as for Expression (9) applies, and the description thereof is omitted. In Expression (20), a symbol other than those in Expression (9) is a winding short-circuit reference evaluation value Δref. In Expression (9), load torque when winding short-circuit has not occurred in the electric motor 7 and the short-circuit rate is zero ($\mu = 0$) is calculated. However, if winding short-circuit occurs and short-circuit current If flows, load torque loss occurs and therefore the corresponding term part cannot be ignored. Therefore, the reference evaluation value calculation unit 23b calculates the winding short-circuit reference evaluation value Δref by Expression (21), using the negative-phase-sequence voltage Vsn calculated by the negative-phase-sequence voltage calculation unit 21c and the negative-phase-sequence current Isn calculated by the negative-phase-sequence current calculation unit 21d. At this time, the calculation is performed with a set initial value substituted into a negative-phase-sequence admittance reference value Yref.

[Mathematical 20]

$$T_e = \frac{3}{2} \cdot \frac{P_p}{2} \left\{ \left( \phi_d \cdot i_q \right) - \left( \phi_q \cdot i_d \right) \right\} - \frac{P_p}{2} \cdot 3\Delta_{ref} \cdot \phi_q \qquad \cdots (20)$$

[Mathematical 21]

$$\Delta_{ref} = \left| I_{sn} - Y_{ref} \cdot V_{sn} \right| = \frac{1}{3}\mu I_f \qquad \cdots \cdots \cdots \cdots \cdots (21)$$

In step 209, the negative-phase-sequence admittance calculation unit 23c calculates the negative-phase-sequence admittance Yn from the load torque calculated by the load torque calculation unit 23a, using the load torque/negative-phase-sequence admittance characteristics shown in FIG. 7 which are stored in the negative-phase-sequence admittance characteristics storage unit 33.

The negative-phase-sequence admittance Yn in the case of considering winding short-circuit cannot be theoretically calculated on the basis of load torque. Therefore, the value of the negative-phase-sequence admittance Yn is calculated from the load torque/negative-phase-sequence admittance characteristics shown in FIG. 7 obtained in the learning period mode.

In step 210, the winding short-circuit evaluation value calculation unit 23d calculates a winding short-circuit evaluation value Δ by Expression (22), using the negative-phase-sequence voltage Vsn calculated by the negative-phase-sequence voltage calculation unit 21c, the negative-phase-sequence current Isn calculated by the negative-phase-sequence current calculation unit 21d, and the negative-phase-sequence admittance Yn calculated by the negative-phase-sequence admittance calculation unit 23c.

[Mathematical 22]

$$\Delta = \left| I_{sn} - Y_n \cdot V_{sn} \right| \quad \cdots \cdots \cdots \cdots (22)$$

In step 211, the winding short-circuit determination unit 24b of the abnormality determination unit 24 determines whether or not the winding short-circuit evaluation value $\Delta$ calculated by the winding short-circuit evaluation value calculation unit 23d is greater than a threshold value.

If the winding short-circuit evaluation value $\Delta$ is smaller than the threshold value (NO), it is determined that winding short-circuit has not occurred in the electric motor 7 and thus the process is ended. If the winding short-circuit evaluation value $\Delta$ is greater than the threshold value (YES), it is determined that winding short-circuit has occurred in the electric motor 7, and in step 212, the fact that winding short-circuit has occurred is output from the determination result output unit 41 of the output unit 40. Thus, the process is ended.

As described above, the winding short-circuit evaluation value $\Delta$ is calculated using the negative-phase-sequence admittance Yn calculated using the load torque/negative-phase-sequence admittance characteristics shown in FIG. 7 obtained in the learning period mode. Thus, the winding short-circuit evaluation value $\Delta$ during operation in a state in which the electric motor 7 is normal (there is no winding short-circuit) can be reduced as shown in FIG. 8. Therefore, it becomes possible to set the threshold value to a smaller value accordingly, whereby minute variation in the winding short-circuit evaluation value due to slight winding short-circuit can be detected by the winding short-circuit determination unit 24b.

In general, the control center at which the electric motor diagnosis device 9 is used is placed and managed in an electric room. Therefore, it is possible to easily monitor multiple electric motors 7 and mechanical equipment 8 in the electric room, without going to the location where the electric motor 7 is operated.

The electric motor diagnosis device of the present invention is applicable to all induction motors that drive plant equipment such as a pump, a fan, a blower, and a conveyer provided in an electric power plant or a chemical plant, and that have temporally varying torques but are not an inverter-driven type.

In the description of Embodiment 1 above, one diagnosis device is provided for each individual electric motor. However, it is also possible to employ a configuration that enables winding short-circuits of a plurality of electric motors to be detected by one diagnosis device by collectively processing information about the plurality of electric motors.

DESCRIPTION OF REFERENCE CHARACTERS

| | |
|---|---|
| 1 | power grid |
| 2 | main circuit |
| 3 | wiring circuit breaker |
| 4 | electromagnetic contactor |
| 5 | voltage detector |
| 6 | current detector |
| 7 | electric motor |
| 8 | mechanical equipment |
| 9 | electric motor diagnosis device |
| 10 | input unit |
| 11 | voltage input unit |
| 12 | current input unit |
| 13 | sampling speed setting unit |
| 14 | rating information input unit |
| 20 | logical calculation unit |
| 21 | voltage/current conversion unit |
| 21a | voltage unbalance rate calculation unit |
| 21b | dq conversion calculation unit |
| 21c | negative-phase-sequence voltage calculation unit |
| 21d | negative-phase-sequence current calculation unit |

| 22 | learning period unit |
|---|---|
| 22a | load torque calculation unit |
| 22b | negative-phase-sequence admittance calculation unit |
| 23 | winding short-circuit analysis unit |
| 23a | load torque calculation unit |
| 23b | reference evaluation value calculation unit |
| 23c | negative-phase-sequence admittance calculation unit |
| 23d | winding short-circuit evaluation value calculation unit |
| 24 | abnormality determination unit |
| 24a | voltage unbalance rate determination unit |
| 24b | winding short-circuit determination unit |
| 30 | storage unit |
| 31 | sampling speed storage unit |
| 31a | forgetting coefficient and scale factor characteristics storage unit |
| 32 | rating information storage unit |
| 33 | negative-phase-sequence admittance characteristics storage unit |
| 40 | output unit |
| 41 | determination result output unit |

**Claims**

1.  An electric motor diagnosis device comprising:

    - a load torque calculation unit (20) that is configured to calculate a load torque of an electric motor (7), using voltage and current sampled and input from a main circuit (2) to which the electric motor (7) is connected;
    - a negative-phase-sequence admittance characteristics storage unit (33) that is configured to store load torque/negative-phase-sequence admittance characteristics obtained in advance when the electric motor (7) is normal;
    - a negative-phase-sequence admittance calculation unit (22b) that is configured to calculate a negative-phase-sequence admittance, $Y_n$, from the load torque calculated by the load torque calculation unit (20), using the load torque/negative-phase-sequence admittance characteristics stored in the negative-phase-sequence admittance characteristics storage unit (33);
    - a winding short-circuit evaluation value calculation unit (23d) that is configured to calculate a winding short-circuit evaluation value, $\Delta$, on the basis of the negative-phase-sequence admittance, $Y_n$, calculated by the negative-phase-sequence admittance calculation unit (22b), the negative-phase-sequence current, $I_{sn}$, calculated from input current, and the negative-phase-sequence voltage, $V_{sn}$, calculated from input voltage according to the following formula:

    $$\Delta = |I_{sn} - Y_n \cdot V_{sn}|;$$

    and
    - a winding short-circuit determination unit (24b) that is configured to determine that winding short-circuit has occurred, when the winding short-circuit evaluation value, $\Delta$, calculated by the winding short-circuit evaluation value calculation unit (23d) is equal to or greater than a threshold value.

2.  The electric motor diagnosis device according to claim 1, further comprising a voltage unbalance rate determination unit (24a) for allowing execution of the calculation by the load torque calculation unit(20) when a maximum difference between each input interphase voltage and average voltage thereamong is 5 % or lower.

**Patentansprüche**

1.  Elektromotor-Diagnosevorrichtung, die Folgendes aufweist:

    - eine Lastdrehmoment-Recheneinheit (20), die konfiguriert ist, ein Lastdrehmoment eines Elektromotors zu berechnen, und zwar unter Verwendung von Spannung und Strom, die von einer Hauptschaltung (2), an welche der Elektromotor (7) angeschlossen ist, abgetastet und eingegeben werden;

- eine Speichereinheit (33) für Negativ-Phasen-Sequenz-Admittanzcharakteristiken, welche dazu ausgelegt ist, eine Lastdrehmoment/Negative-Phasen-Sequenz-Admittanzcharakteristik zu speichern, die vorher erhalten worden ist, wenn der Elektromotor (7) normal ist;

- eine Recheneinheit (22b) für Negativ-Phasen-Sequenz-Admittanzen, die dazu ausgelegt ist, eine Negativ-Phasen-Sequenz-Admittanz $Y_n$ zu berechnen, und zwar aus dem Lastdrehmoment, das von der Lastdrehmoment-Recheneinheit (20) berechnet worden ist, und zwar unter Verwendung der Lastdrehmoment/Negativ-Phasen-Sequenz-Admittanzcharakteristiken, die in der Speichereinheit (33) für Negativ-Phasen-Sequenz-Admittanzcharakteristiken gespeichert sind;

- eine Recheneinheit (23d) für Windungs-Kurzschluss-Auswertungswerte, die dazu ausgelegt ist, einen Windungs-Kurzschluss-Auswertungswert $\Delta$ zu berechnen, und zwar auf der Basis der Negativ-Phasen-Sequenz-Admittanz $Y_n$, die von Recheneinheit (22b) für Negativ-Phasen-Sequenz-Admittanzen berechnet worden ist, dem Negativ-Phasen-Sequenz-Strom $I_{sn}$, der aus dem Eingangsstrom berechnet worden ist, und der Negativ-Phasen-Sequenz-Spannung $V_{sn}$, welche aus der Eingangsspannung berechnet worden ist, und zwar gemäß der nachstehenden Formel:

$$\Delta = |I_{sn} - Y_n \cdot V_{sn}|;$$

und

- eine Windungs-Kurzschluss-Bestimmungseinheit (24b), die dazu ausgelegt ist, zu bestimmen, dass ein Windungs-Kurzschluss stattgefunden hat, wenn der Windungs-Kurzschluss-Auswertungswert $\Delta$, der von der Recheneinheit (23d) für Windungs-Kurzschluss-Auswertungswerte berechnet worden ist, gleich dem oder größer als ein Schwellenwert ist.

2. Elektromotor-Diagnosevorrichtung nach Anspruch 1,
die eine Bestimmungseinheit (24) für Spannungs-Unsymmetriewerte aufweist, um die Ausführung der Berechnung durch die Lastdrehmoment-Recheneinheit (20) zu ermöglichen, wenn eine maximale Differenz zwischen der jeweiligen Eingangs-Zwischenphasenspannung und der durchschnittlichen Spannung von diesen 5 % oder weniger ist.


**Revendications**

1. Dispositif de diagnostic de moteur électrique comprenant :

- une unité de calcul de couple de charge (20) qui est configurée pour calculer un couple de charge d'un moteur électrique (7) en utilisant une tension et un courant échantillonnés et entrés depuis un circuit principal (2) auquel le moteur électrique (7) est connecté ;
- une unité de stockage de caractéristiques d'admittance inverse (33) qui est configurée pour stocker des caractéristiques couple de charge/admittance inverse obtenues à l'avance lorsque le moteur électrique (7) est normal ;
- une unité de calcul d'admittance inverse (22b) qui est configurée pour calculer une admittance inverse, $Y_n$, à partir du couple de charge calculé par l'unité de calcul de couple de charge (20), en utilisant les caractéristiques couple de charge/admittance inverse stockées dans l'unité de stockage de caractéristiques d'admittance inverse (33) ;
- une unité de calcul de valeur d'évaluation de court-circuit d'enroulement (23d) qui est configurée pour calculer une valeur d'évaluation de court-circuit d'enroulement, $\Delta$, sur la base de l'admittance inverse, $Y_n$, calculée par l'unité de calcul d'admittance inverse (22b), du courant inverse, $I_{sn}$, calculé à partir du courant d'entrée, et de la tension inverse, $V_{sn}$, calculée à partir de la tension d'entrée selon la formule suivante :

$$\Delta = |I_{sn} - Y_n \cdot V_{sn}| \; ;$$

et

- une unité de détermination de court-circuit d'enroulement (24b) qui est configurée pour déterminer qu'un court-circuit d'enroulement s'est produit lorsque la valeur d'évaluation de court-circuit d'enroulement, $\Delta$, calculée par l'unité de calcul de valeur d'évaluation de court-circuit d'enroulement (23d) est égale ou supérieure à une valeur seuil.

2. Dispositif de diagnostic de moteur électrique selon la revendication 1, comprenant en outre une unité de détermination de taux de déséquilibre de tension (24a) pour permettre l'exécution du calcul par l'unité de calcul de couple de charge (20) lorsqu'une différence maximale entre chaque tension interphase d'entrée et la tension moyenne entre elles est de 5 % ou moins.

EP 3 376 242 B1

## FIG. 1

# FIG. 2

20

**LOGICAL CALCULATION UNIT** — 21

**VOLTAGE/CURRENT CONVERSION UNIT** — 21a

VOLTAGE UNBALANCE RATE CALCULATION UNIT — 21b

dq CONVERSION CALCULATION UNIT — 21c

NEGATIVE-PHASE-SEQUENCE VOLTAGE CALCULATION UNIT — 21d

NEGATIVE-PHASE-SEQUENCE CURRENT CALCULATION UNIT

**LEARNING PERIOD UNIT** — 22

LOAD TORQUE CALCULATION UNIT — 22a

NEGATIVE-PHASE-SEQUENCE ADMITTANCE CALCULATION UNIT — 22b

**WINDING SHORT-CIRCUIT ANALYSIS UNIT** — 23

LOAD TORQUE CALCULATION UNIT — 23a

REFERENCE EVALUATION VALUE CALCULATION UNIT — 23b

NEGATIVE-PHASE-SEQUENCE ADMITTANCE CALCULATION UNIT — 23c

WINDING SHORT-CIRCUIT EVALUATION VALUE CALCULATION UNIT — 23d

**ABNORMALITY DETERMINATION UNIT** — 24

VOLTAGE UNBALANCE RATE DETERMINATION UNIT — 24a

WINDING SHORT-CIRCUIT DETERMINATION UNIT — 24b

# FIG. 3

STORAGE UNIT 30

SAMPLING SPEED STORAGE UNIT 31

FORGETTING COEFFICIENT AND
SCALE FACTOR CHARACTERISTICS
STORAGE UNIT 31a

RATING INFORMATION STORAGE UNIT 32

NEGATIVE-PHASE-SEQUENCE ADMITTANCE
CHARACTERISTICS STORAGE UNIT 33

FIG. 4

# FIG. 5

```
                        ┌──────────┐
                        │  START   │
                        └──────────┘
                             │
101                          ▼
        ┌───────────────────────────────────────┐
        │   INPUT VOLTAGE AND CURRENT            │
        └───────────────────────────────────────┘
102                          │
                             ▼
        ┌───────────────────────────────────────┐
        │   CALCULATE VOLTAGE                    │
        │   UNBALANCE RATE                       │
        └───────────────────────────────────────┘
103                          │                        104
                             ▼
            ╱──────────────────────────╲    NO   ┌──────────────────────┐
           ╱    VOLTAGE                  ╲───────▶│  VOLTAGE UNBALANCE   │
           ╲  UNBALANCE RATE IS 5%       ╱        │  HAS OCCURRED        │
            ╲    OR LOWER?              ╱         └──────────────────────┘
             ╲────────────────────────╱
                             │ YES
105                          ▼
        ┌───────────────────────────────────────┐
        │   PERFORM d-AXIS,                      │
        │   q-AXIS CONVERSION                    │
        └───────────────────────────────────────┘
106                          │
                             ▼
        ┌───────────────────────────────────────┐
        │   CALCULATE NEGATIVE-PHASE-            │
        │   SEQUENCE VOLTAGE                     │
        └───────────────────────────────────────┘
107                          │
                             ▼
        ┌───────────────────────────────────────┐
        │   CALCULATE NEGATIVE-PHASE-            │
        │   SEQUENCE CURRENT                     │
        └───────────────────────────────────────┘
108                          │
                             ▼
        ┌───────────────────────────────────────┐
        │   CALCULATE LOAD TORQUE WHEN           │
        │   ELECTRIC MOTOR IS NORMAL            │
        └───────────────────────────────────────┘
109                          │
                             ▼
        ┌───────────────────────────────────────┐
        │   CALCULATE NEGATIVE-PHASE-            │
        │   SEQUENCE ADMITTANCE IN              │
        │   NORMAL CASE                         │
        └───────────────────────────────────────┘
110                          │
                             ▼
            ╱──────────────────────────╲    NO
           ╱    LEARNING PERIOD         ╲───────▶
           ╲    HAS FINISHED?           ╱
            ╲────────────────────────╱
111                          │ YES
                             ▼
        ┌───────────────────────────────────────┐
        │   STORE LOAD TORQUE/                   │
        │   NEGATIVE-PHASE-SEQUENCE             │
        │   ADMITTANCE CHARACTERISTICS          │
        └───────────────────────────────────────┘
                             │
                             ▼
                        ┌──────────┐
                        │   END    │
                        └──────────┘
```

## FIG. 6

101 INPUT VOLTAGE AND CURRENT

102 CALCULATE VOLTAGE UNBALANCE RATE

103 VOLTAGE UNBALANCE RATE IS 5% OR LOWER? — NO → 104 VOLTAGE UNBALANCE HAS OCCURRED

YES

105 PERFORM d-AXIS, q-AXIS CONVERSION

106 CALCULATE NEGATIVE-PHASE-SEQUENCE VOLTAGE

107 CALCULATE NEGATIVE-PHASE-SEQUENCE CURRENT

208 CALCULATE LOAD TORQUE CONSIDERING WINDING SHORT-CIRCUIT

209 CALCULATE NEGATIVE-PHASE-SEQUENCE ADMITTANCE FROM CHARACTERISTICS

210 CALCULATE WINDING SHORT-CIRCUIT EVALUATION VALUE

211 EVALUATION VALUE > THRESHOLD VALUE? — NO

YES

212 OUTPUT DETERMINATION RESULT THAT WINDING SHORT-CIRCUIT HAS OCCURRED

END

FIG. 7

FIG. 8

**EP 3 376 242 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5477163 A

- JP 2012220485 A